# EUROPEAN PATENT APPLICATION

(11) **EP 4 697 072 A1**
(43) Date of publication of application: **18.02.2026**
(21) Application number: 24204990.6
(22) Date of filing: 07.10.2024
(51) Int. Cl.: G02B 6/42, H01L 23/433, H01L 23/367, H01L 23/42, H01L 23/40, H01L 23/38, H01L 23/473, H01L 25/065

(54) **THERMAL DISSIPATION SYSTEM FOR INTEGRATED CIRCUIT CHIPS**

(30) Priority: 16.08.2024 US 202418807653
(71) Applicant: II-VI Delaware, Inc., Wilmington, Delaware 19801 (US)
(72) Inventor: NGUYEN, Long Van, San Jose, 95135 (US); KOUTROKOIS, Demetrios, San Francisco, 94107 (US); TRUONG, Long Hong, Milpitas, 95035 (US)
(74) Representative: Forresters IP LLP

(57) **Abstract**

A thermal dissipation system for an integrated circuit (IC) includes an IC disposed on a substrate and a heat sink including a body having a first surface including a first part coupled to a side of the IC opposite the substrate and a second part disposed away from the IC and positioned in spaced relation to the substrate. A set of legs support at least the second part of the body in spaced relation to the substrate. The set of legs may be part of the body or may be part of a carrier disposed between the second part of the first surface of the body and the substrate. The carrier includes an opening through which a portion of the substrate that includes the first part that is coupled to the side of the IC opposite the substrate extends.

## Description

### BACKGROUND

### Field

The present disclosure relates to a system for dissipating heat from integrated circuits (ICs) and, more particularly, for dissipating heat from ICs used in optical transceivers.

### Background

In optical transceiver modules, power consumption of ICs continues to increase. In the same limited space, larger amounts of heat need to be dissipated with every product iteration. The physics that governs the performance of heat dissipation or "cooling" of the ICs is the thermal resistance.

It would therefore be desirable to provide a system that helps reduces thermal resistance from the ICs to the cooling side of the optical transceiver module that is easy to manufacture in an efficient and reliable fashion.

### SUMMARY

Disclosed is a thermal dissipation system for integrated circuits that comprises a substrate, a set of integrated circuits (ICs) disposed on the substrate, and a carrier coupled to the substrate. The carrier has a side, including a set of openings, disposed in spaced relation to the substrate with the set of ICs disposed between the substrate and the set of openings. A set of heat sinks is disposed on a surface of the side of the carrier opposite the set of ICs. Each heat sink includes a portion in contact with the surface of the side of the carrier opposite the set of ICs and a projection or extension that extends through one of the openings toward, and desirably into contact with, one of the ICs of the set of ICs.

Also disclosed is a thermal dissipation system for integrated circuits that comprises a substrate supporting an integrated circuit (IC) and a carrier including a side disposed in spaced relation to a side of the substrate supporting the IC. A heat sink is in contact with the IC. The heat sink includes a projection or extension that extends from the IC through an opening in the side of the carrier. After passage through the opening in the side of the carrier, the heat sink includes a portion that extends away from the opening in the side of the carrier along a surface of the side of the carrier opposite the IC.

The system may further include the substrate supporting another IC and another heat sink in contact with the other IC. The other heat sink may include a projection or extension that extends away from the other IC through another opening in the side of the carrier. After passage through the other opening in the side of the carrier, the other heat sink may include a portion that extends away from the other opening in the side of the carrier along the surface of the side of the carrier opposite the other IC.

Also disclosed herein is a thermal dissipation system for integrated circuits that comprises a heat sink having a first part including a planar or substantially planar first surface in contact with an integrated circuit (IC) that is mounted on a substrate and a second part spaced from the IC. The second part of the heat sink includes a planar or substantially planar second surface that faces away from the first surface in spaced or substantially spaced parallel relation to the first surface. The second surface has a surface area greater than the first surface. A carrier is coupled between the substrate and the second part of the heat sink. The carrier supports the second part of the heat sink in spaced or substantially spaced parallel relation to the substrate. The first part of the heat sink extends between the IC and the second part of the heat sink through an opening in the carrier.

The carrier may be coupled to the substrate via legs. The legs may extend from the carrier to a side of the substrate opposite the carrier.

The carrier may include standoffs that extend between the carrier and the substrate for maintaining or supporting the carrier and the substrate in spaced relation.

Finally, disclosed herein is a thermal dissipation system for an integrated circuit that comprises a substrate supporting an integrated circuit (IC) and a heat sink comprising a body having first surface including a first part or portion in contact with the IC, a second surface that faces away from the IC, and one or more legs that extend between the body of the heat sink and the substrate and support a second part or portion of the first surface of the heat sink disposed away from the IC in spaced relation to the substrate.

A distal end of each leg disposed away from the body of the heat sink may be coupled to the substrate, e.g., via an adhesive.

### BRIEF DESCRIPTION OF THE DRAWINGS

Fig. 1A is a top-down exploded perspective view of a thermal dissipation system for integrated circuit chips in accordance with the principles of this disclosure;
Fig. 1B is a bottom-up exploded perspective view of the thermal dissipation system of Fig. 1;
Fig. 2A is a perspective view of the partially assembly thermal dissipation system for integrated circuit chips shown in Figs. 1A and 1B;
Fig. 2B is an enlarged side view a single one of the legs of the carrier shown in Fig. 2A used to connect the carrier to the substrate on which the ICs are mounted;
Fig. 3 is cross-section taken along lines III-III in Fig. 2A;
Fig 4 is a perspective view of another thermal dissipation system for integrated circuit chips in accordance with the principles of this disclosure; and
Fig. 5 is a side view of the thermal dissipation system shown in Fig. 4

### DETAILED DESCRIPTION

Various non-limiting embodiments will now be described with reference to the accompanying figures where like reference numbers correspond to like or functionally equivalent elements or features.

As used herein, spatial, or directional terms, such as "left", "right", "inner", "outer", "above", "below", and the like, relate to the disclosure as it is shown in the drawing figures. However, it is to be understood that the disclosure can assume various alternative orientations and, accordingly, such terms are not to be considered as limiting. Further, as used herein, all numbers expressing dimensions, physical characteristics, processing parameters, quantities of ingredients, reaction conditions, and the like, used in the specification and claims are to be understood as being modified in all instances by the term "approximately" or "about". Accordingly, unless indicated to the contrary, the numerical values set forth in the following specification and claims may vary depending upon the desired properties sought to be obtained by the present disclosure.

At the very least, and not as an attempt to limit the application of the doctrine of equivalents to the scope of the claims, each numerical value should at least be construed in light of the number of reported significant digits and by applying ordinary rounding techniques. Moreover, all ranges disclosed herein are to be understood to encompass the beginning and ending range values and any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more and ending with a maximum value of 10 or less, e.g., 1 to 3.3, 4.7 to 7.5, 5.5 to 10, and the like. "A" or "an" refers to one or more.

As used herein, "coupled", "coupling", and similar terms refer to two or more elements that are joined, linked, fastened, connected, put in communication, or otherwise associated (e.g., mechanically, electrically, fluidly, optically, electromagnetically) with one another. In various examples, the elements may be associated directly or indirectly. As an example, element A may be directly associated with element B. As another example, element A may be indirectly associated with element B, for example, via another element C. It will be understood that not all associations among the various disclosed elements are necessarily represented. Accordingly, couplings other than those depicted in the figures may also exist.

As used herein, the phrase "at least one of', when used with a list of items, means different combinations of one or more of the listed items may be used and only one of each item in the list may be needed. For example, "at least one of item A, item B, and item C" may include, without limitation, item A or item A and item B. This example also may include item A, item B, and item C, or item B and item C. In other examples, "at least one of" may be, for example, without limitation, two of item A, one of item B, and ten of item C; four of item B and seven of item C; and other suitable combinations.

Herein, each "set" may comprise one or more elements or members.

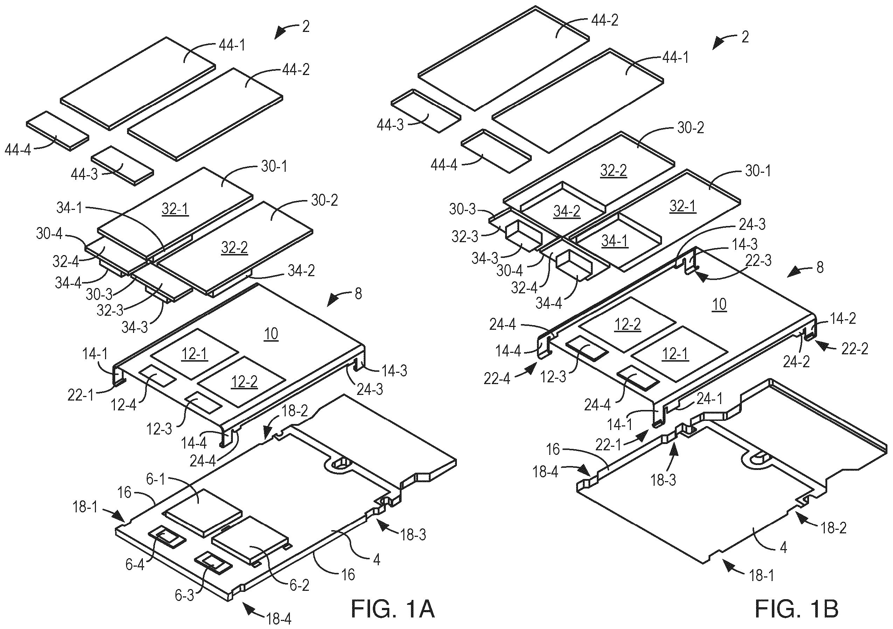

With reference to Figs. 1A-1B, an example thermal dissipation system 2 in accordance with the principles of the present disclosure may comprise a substrate 4, e.g., a printed circuit board (PCB), upon which a set of integrated circuits (ICs) 6 may be mounted in a manner known in the art. The set of ICs 6 shown in Figs. 1A and 1B may include, for example, four ICs 6-1 - 6-4. However, this is not to be construed in a limiting sense since the set of ICs 6 may include any number of one or more ICs as may be deemed suitable and/or desirable for an application. Moreover, one or more or all of the ICs 6 may be an open die IC where the IC chip is exposed, i.e., the IC chip does not have a protective covering or packaging around it. However, this is not to be construed in a limiting sense since one or more or all of the ICs 6 may include a protective covering or packaging around it. Moreover, combinations of ICs 6 including protective coverings or packagings and open die ICs is envisioned.

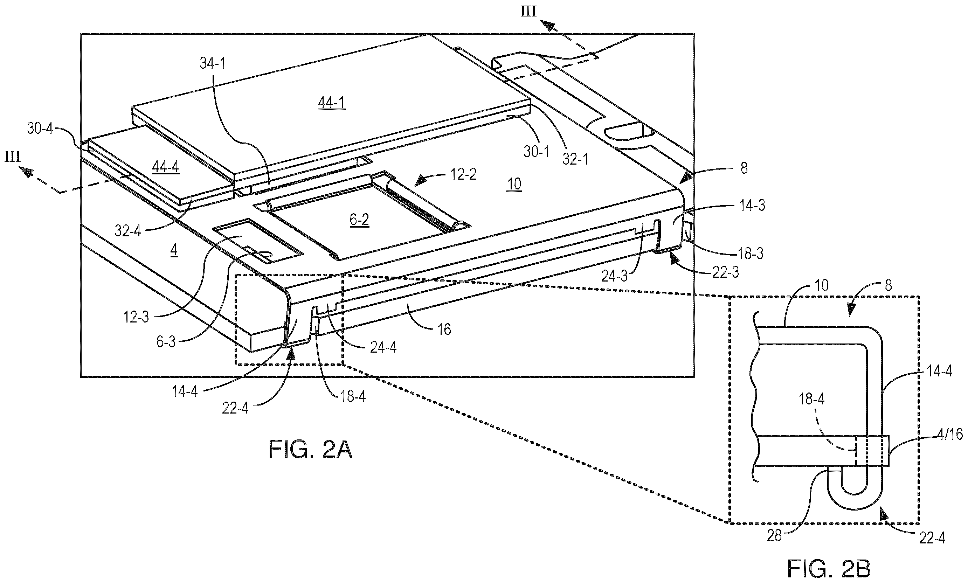

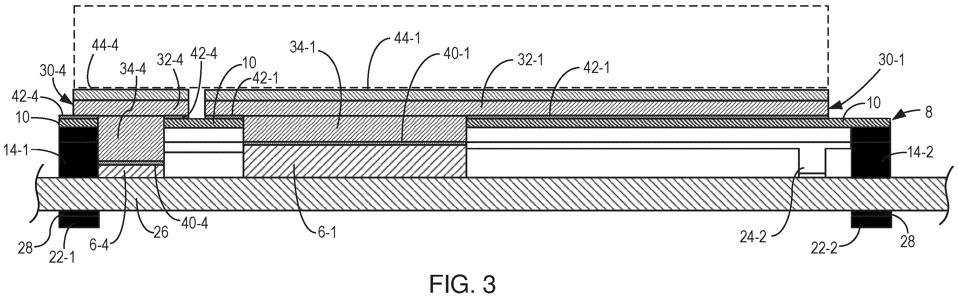

With reference to Figs. 2A-2B and 3 and with continuing reference to Figs. 1A-1B, a carrier 8 may be coupled to the substrate 4. The carrier 8 may have a side 10 including a set of openings 12 in spaced relation to the substrate 4 with the set of ICs 6 disposed between the substrate 4 and the set of openings 12. The set of openings 12 shown in Figs. 1A and 1B may include, for example, four openings 12-1 - 12-4 in spaced relation to ICs 6-1 - 6-4. However, this is not to be construed in in a limiting sense since the set of openings 12 may include any number of openings as may be deemed suitable and/or desirable for an application. In an example, the number of openings 12 is the same as the number of ICs 6. However, this is not to be construed in a limiting sense since it is envisioned that the number of openings 12 and the number of ICs 6 may be different.

In an example, the carrier 8 may be coupled to the substrate 4 via a set of legs 14 that extend or depend from the side of the carrier 8 past side edges 16 of the substrate 4. In an example, the side edges 16 of substrate 4 may include slots 18 for receiving the set of set of legs 14. In an example, the set of legs 14 includes legs 14-1 - 14-4 received in the set of slots 18 which includes slots 18-1 - 18-4. However, this is not to be construed in a limiting sense since it is envisioned that the number of legs 14 and/or the number of slots 18 may be different.

The distal end 22 of each leg 14 that extends in a slot 18 past one of the side edges 16 of the substrate 4 may be bent or curved, e.g., in the form of a J-shape or hook, toward an underside of the substrate 4 opposite the side 10 of carrier 8. Fig. 1B shows legs 14-1 - 14-4 including distal ends 22-1 - 22-4 that are bent or curved. Fig 2B shows leg 14-4 extending in slot 18-4, where leg 14-4 includes distal end 22-4 that is bent or curved, e.g., in the form of a J-shape or hook, toward and preferably into contact with the side of the substrate 4 opposite the side 10 of carrier 8. As shown best in Fig. 2B, the distal end of each leg 14 may be joined to the side of substrate 4 opposite the carrier 10 by a suitable adhesive 28, e.g., an epoxy.

Adjacent each leg 14 the carrier 8 may include a standoff 24 that aids in setting a distance the side 10 of the carrier 8 is spaced from the surface 26 of substrate 4 that faces the side 10 of carrier 8. In an example, the carrier 8 may include standoffs 24-1 - 24-4 adjacent legs 14-1 - 14-4. However, this is not to be construed in a limiting sense since it is envisioned that the number of and location of each standoff 24, if provided, may be different.

A set of heat sinks 30 may be disposed on the surface of the side 10 of the carrier 8 opposite the set of ICs 6 and/or substrate 4. Each heat sink 30 may include a top portion 32 (e.g., a planar top portion) in contact with the surface of the side 10 of the carrier 8 opposite the set of ICs 6 and/or substrate 4 and a projection or extension 34 that extends through one of the openings 12 toward one of the ICs 6. In the example shown in Figs. 1A-2A, the set of heat sinks 30 include heat sinks 30-1 - 30-4 including portions 32-1 - 32-4 and projections or extension 34-1 - 34-4 that may extend through openings 12-1 - 12-4 toward ICs 6-1 - 6-4. However, this is not to be construed in a limiting sense since it is envisioned that the number heat sinks 30, each including a portion 32 and a projection or extension 34, the number of openings 12, and the number of ICs 6 may be different.

As shown best in Fig. 3 and as may be understood from Figs.1A - 2B, the distal ends of the projections or extensions 34 opposite the top portions 32 of the heat sinks 30 may be positioned in contact with or in spaced relation to the topsides of the ICs 6. To aid thermal contact between the topsides of the IC's 6 and the distal ends of the projections or extensions 34 opposite the top portions 32 of the heat sinks 30, an optional thermal interface 40 may be positioned or disposed between and in contact with the distal end of each projection or extension 34 and the topside of the corresponding IC 6.

For example, as shown in Fig. 3, a thermal interface 40-1 may be disposed between and in contact with both the distal end of projection or extension 34-1 and the topside of IC 6-1 and a thermal interface 40-4 may be disposed between and in contact with both the distal end of projection or extension 34-4 and the topside of IC 6-4. The thermal interface 40 used between each projection or extension 34 and the topside of the corresponding IC 6 may be same or different. In an example, each thermal interface 40 may be one or more of a thermal paste, a thermal pad, a thermal adhesive, a phase change material, a thermal grease, and/or a thermal gap filler.

Each heat sink 30 may also be coupled to the side 10 of carrier 8 via an optional thermal interface 42 disposed between and in contact with both the heat sink 30 and the side 10 of carrier 8. For example, as shown in Fig. 3, a thermal interface 42-1 may be disposed between and in contact with both the underside of the top portion 32-1 of the heat sink 30-1 and the corresponding part or portion of the top of the side 10 of the carrier 8 and a thermal interface 42-4 may be disposed between and in contact with both the underside of the top portion 32-4 of the heat sink 30-4 and the corresponding portion of the top of the side 10 of the carrier 8. The thermal interface 42 used between each heat sink 30 and the side 10 of carrier 8 may be same or different. In an example, the thermal interface 42 may be one or more of a thermal paste, a thermal pad, a thermal adhesive, a phase change material, a thermal grease, and/or a thermal gap filler.

Finally, each heat sink 30 may also include an optional thermal interface 44 disposed atop of the portion 32 over the projection or extension 34 of the heat sink 30. For example, as shown in Fig. 3, a thermal interface 44-1 may be disposed atop of portion 32-1 above projection or extension 34-1 and a thermal interface 44-4 may be disposed atop of portion 32-4 above projection or extension 34-4. The thermal interface 44 disposed atop of the portion 32 over the projection or extension 34 of each heat sink 30 may be same or different. In an example, each thermal interface 44 may be one or more of a thermal paste, a thermal pad, a thermal adhesive, a phase change material, a thermal grease, and/or a thermal gap filler.

In an example, each thermal interface 44 may be disposed between the top projection or extension 34 of one of the heat sinks 30 and an optional cooler 46 (shown in dashed lines), e.g., a thermo-electric cooler or a liquid cooler.

As can be seen, disclosed are heat sinks or heat spreaders 30 that may sit atop of ICs 6. Each heat sink 30 may be larger than the IC 6 upon which the heat sink 30 and may be die cast to achieve intricate shapes required to work with adjacent components. In an example, the heat sink 30 material can be aluminum, or copper and the heat sink 30 may be made using a Metal injection Molding (MIM) process.

In an example, each heat sink 30 may be thick and wide, and may significantly grow the contact area to an IC 6 over prior art heat sinks. The heat sink 30 may accomplish this via top portions 32 hovering in spaced relation over other components mounted on the substrate 4 proximate or adjacent the IC 6 itself thereby allowing the contact between the heat sink 30 and the IC 6 to be of a much larger over prior art thermal interfaces. Utilizing this larger thermal contact area decreases the thermal resistance, which is inversely proportional to thermal contact surface area, in a linear fashion.

Another advantage is saving real estate on the substrate 4. The heat sink or heat spreader 30 may be assembled onto the carrier 8 that has a number, e.g., four, legs 14 positioned to the outside of the substrate 4 which is not used for placement of components. The carrier 4 may accommodate heat sinks 30 of multiple IC's 6 that would otherwise each require three or four legs each.

Another advantage is the ability to couple the heat sinks 30 to the carrier 8 via one or more thermal interfaces 40, 42, and/or 44, without having to precisely control the quantity and location of the one or more thermal interfaces, which may be challenging in dense and tight spaces. Accordingly, mass production of the thermal dissipation system 2 in accordance with the principles of the present disclosure may be facilitated.

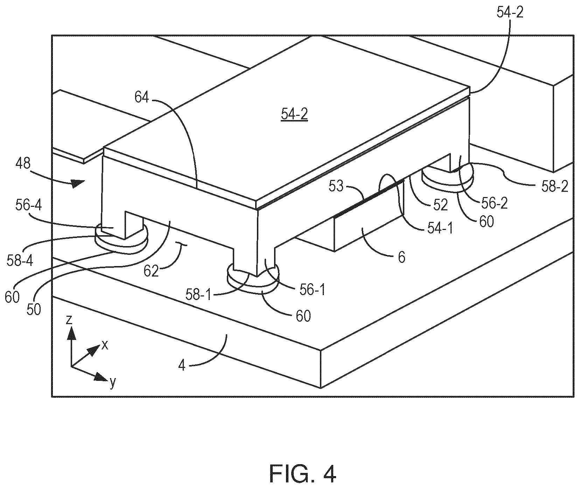

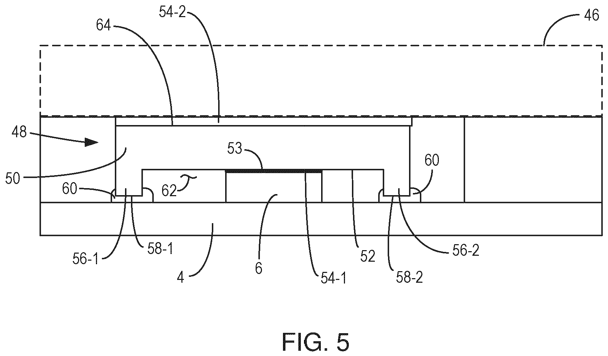

With reference to Figs. 4 and 5, another example thermal dissipation system 2 in accordance with the principles of the present disclosure may comprise a substrate 4, e.g., a printed circuit board (PCB), upon which a set of integrated circuits (ICs) 6 may be mounted in a manner known in the art. The set of ICs 6 shown in Figs. 4 and 5 may include, for example, a single IC 6. However, this is not to be construed in a limiting sense since the set of ICs 6 may include any number of one or more ICs 6 as may be deemed suitable and/or desirable for an application. Moreover, one or more or all of the set of ICs 6 may be an open die IC where the IC chip is exposed, i.e., the IC chip does not have a protective covering or packaging around it. However, this is not to be construed in a limiting sense since one or more or all of the set of ICs 6 may include a protective covering or packaging around it. Moreover, combinations of ICs 6 including protective coverings or packagings and open die ICs is envisioned.

A heat sink 48 may be disposed on top of the set of ICs 6 (in this example, a single IC 6). In an example, the heat sink 48 may comprise a body 50 including a first, bottom surface 52, that faces the IC 6 and the substrate 4, and which may have a first part or portion (e.g., a planar portion) in contact with a top surface 53 of the IC 6. An optional first thermal interface 54-1 may be disposed between and in contact with both the top surface 53 of the IC 6 and the first part or portion of the bottom surface 52 of the body 50 which is immediately above the top surface 53 of the IC 6.

The bottom surface 52 of the body 50 may also include a second part or portion that extends, e.g., laterally, in one or more directions, e.g., the X and Y directions shown in Fig. 4, away from the first part or portion of the bottom surface 52 of the body 50 above the top surface 53 of the IC 6. Away from first part or portion of the bottom surface 52 of the body 50 above the top surface 53 of the IC 6, the body 50 of the heat sink 48 may include one or more legs 56 that extend downward from the bottom surface 52 of body 50 toward the top surface of the substrate 4. The example heat sink 48 shown in Figs. 4 and 5 may have box shaped body 50 including at the corners thereof four legs 56-1 - 56-4 (wherein leg 56-3 is not illustrated) that extend from the bottom surface 52 of body 50 toward the top surface of the substrate 4. However, this not to be construed in a limiting sense since it is envisioned that body 50 may have any suitable and/or desirable shape. Moreover, the number and location of the legs 56 at the corners of the body 50 shown in Figs. 4 and 5 are not to be construed in a limiting sense since it is envisioned that heat sink 48 may include any number of legs 56 as may be deemed suitable and/or desirable for a particular application and each leg 56 may extend from any location of the body 50 as may be deemed suitable and/or desirable for a particular application.

A distal end 58 of each leg 56 positioned away from the body 50 may be secured to the top surface of the substrate 4, for example via a suitable adhesive or glue 60, thereby securing the body 50 of the heat sink 48 in spaced relation to the substrate 4 with a gap 62 between the top surface of the substrate 4 and the second part or portion of bottom surface 52 of the body 50 that faces the top surface of the substrate 4, i.e., the portion of the bottom surface 52 of the body 50 disposed away from, and not in vertical alignment with, the top surface 53 of the IC 6. Figs. 4 and 5 shown the distal ends 58-1, 58-2, and 58-4 of legs 56-1, 56-2, and 56-4, respectively.

As can be seen, Figs. 4 and 5 disclose a heat sink 48 that may sit atop of one or more ICs 6. The heat sink 48 may be larger than the one or more ICs 6 upon which the heat sink 48 is placed and may be die cast to achieve intricate shapes required to work with adjacent components. In an example, the heat sink 48 material can be aluminum, or copper and the heat sink 48 may be made using a Metal injection Molding (MIM) process.

The heat sink 48 may include a second, top surface 64 (e.g., a planar top surface) that faces away from the substrate 4 and an optional second thermal interface 54-2 may be disposed on top of the top surface 64. In an example, an optional cooler 46 (shown in dashed lines) may be disposed on the top surface 64 with the second thermal interface 54-2 disposed between the top surface 64 of the heat sink 48 and the optional cooler 46.

Each thermal interface 54 may be same or different. In an example, each thermal interface 54 may be one or more of a thermal paste, a thermal pad, a thermal adhesive, a phase change material, a thermal grease, and/or a thermal gap filler.

While Figs. 4 and 5 show a single IC 6 coupled to heat sink 48, this is not to be construed in a limiting sense since it is envisioned that two or more ICs 6 may be coupled to a single heat sink 48.

Other non-limiting examples or aspects of this disclosure are set forth in the following illustrative and exemplary numbered clauses:

Clause 1: A thermal dissipation system for integrated circuits comprises a substrate, a set of integrated circuits (ICs) disposed on the substrate, and a carrier coupled to the substrate. The carrier has a side, including a set of openings, disposed in spaced relation to the substrate with the set of ICs disposed between the substrate and the set of openings. A set of heat sinks is disposed on a surface of the side of the carrier opposite the set of ICs. Each heat sink includes a portion in contact with the surface of the side of the carrier opposite the set of ICs and a projection or extension that extends through one of the openings toward, and desirably into contact with, one of the ICs of the set of ICs.

Clause 2: The system of clause 1, wherein: the set of ICs may include one or more ICs; and/or the set of openings may include one or more openings; and/or the set of heat sinks may include one or more heat sinks.

Clause 3: The system of clause 1 or 2 may include a first set of thermal interfaces disposed between the set of ICs and the projection(s) or extension(s) of the set of heat sinks.

Clause 4: The system of any one of clauses 1-3 may include a second set of thermal interfaces disposed between the portion(s) of the set of heat sinks and the surface of the side of the carrier opposite the set of ICs.

Clause 5: The system of any one of clauses 1-4 may include a third set of thermal interfaces disposed on surface(s) of the set of heat sinks opposite the carrier.

Clause 6: The system of any one of clauses 1-5, wherein each thermal interface may comprise at least one of the following: a thermal paste; a thermal pad; a thermal adhesive; a phase change material; a thermal grease; and/or a thermal gap filler.

Clause 7: The system of any one of clauses 1-6, wherein the carrier may include legs that extend from the carrier past one or more edges of the substrate. Portions of the legs that that extend past the one or more edges of the substrate may be bent or curved toward a surface of the substrate opposite the side of the carrier.

Clause 8: The system of any one of clauses 1-7, wherein the portions of the legs that that extend past the one or more edges of the substrate may be bent or curved whereupon distal ends of the legs contact the surface of the substrate opposite the side of the carrier.

Clause 9: The system of any one of clauses 1-8, wherein the portion of each leg that that extends past the one or more edges of the substrate may be bent or curved into the form of a J-shape or a hook.

Clause 10: A thermal dissipation system for integrated circuits comprises a substrate supporting an integrated circuit (IC) and a carrier including a side disposed in spaced relation to a side of the substrate supporting the IC. A heat sink is in contact with the IC. The heat sink includes a projection or extension that extends from the IC through an opening in the side of the carrier. After passage through the opening in the side of the carrier, the heat sink includes a portion that extends away from the opening in the side of the carrier along a surface of the side of the carrier opposite the IC.

Clause 11: The system of clause 10 may include a first thermal interface disposed between the IC and the projection or extension of the heat sink.

Clause 12: The system of clause 10 or 11 may include a second thermal interface disposed between carrier and the portion of the heat sink.

Clause 13: The system of any one of clauses 10- 12 may include third thermal interface disposed on a surface of the heat sink opposite the carrier.

Clause 14: The system of any one of clauses 10-13, wherein each thermal interface may comprise one or more of the following: a thermal paste; a thermal pad; a thermal adhesive; a phase change material; a thermal grease; and/or a thermal gap filler.

Clause 15: The system any one of clauses 10-14 may further include the substrate supporting another IC and another heat sink in contact with the other IC. The other heat sink may include a projection or extension that extends away from the other IC through another opening in the side of the carrier. After passage through the other opening in the side of the carrier, the other heat sink may include a portion that extends away from the other opening in the side of the carrier along the surface of the side of the carrier opposite the other IC.

Clause 16: The system of one of clauses 10-15, wherein the portions of the heat sink and the other heat sink may be spaced from each other on the carrier.

Clause 17: The system of one of clauses 10-16, wherein the carrier may include legs that extend from the carrier past a surface of the substrate opposite the carrier. Portions of the legs that that extend past the surface of the substrate opposite the carrier may be bent or curved toward the surface of the substrate opposite the carrier.

Clause 18: The system of one of clauses 10-17, wherein the portions of the legs that that extend past the surface of the substrate opposite the carrier may be bent or curved whereupon distal ends of the legs contact the surface of the substrate opposite the carrier.

Clause 19: The system of one of clauses 10-18, wherein the portion of each leg that that extends past the surface of the substrate opposite the carrier may be bent or curved into the form a J-shape or a hook.

Clause 20: A thermal dissipation system for integrated circuits comprises a heat sink having a first part including a planar or substantially planar first surface in contact with an integrated circuit (IC) that is mounted on a substrate and a second part spaced from the IC. The second part of the heat sink includes a planar or substantially planar second surface that faces away from the first surface in spaced or substantially spaced parallel relation to the first surface. The second surface has a surface area greater than the first surface. A carrier is coupled between the substrate and the second part of the heat sink. The carrier supports the second part of the heat sink in spaced or substantially spaced parallel relation to the substrate. The first part of the heat sink extends between the IC and the second part of the heat sink through an opening in the carrier.

Clause 21: The system of clause 20, wherein the carrier may be coupled to the substrate via legs. The legs may extend from the carrier to a side of the substrate opposite the carrier.

Clause 22: The system of clause 20 or 21, wherein the carrier may include standoffs that extend between the carrier and the substrate. The standoffs may maintain or support the carrier and the substrate in spaced relation.

Clause 23: A thermal dissipation system for an integrated circuit comprises a substrate supporting an integrated circuit (IC) and a heat sink comprising a body having first surface including a first part or portion in contact with the IC, a second surface that faces away from the IC, and one or more legs that extend between the body of the heat sink and the substrate and support a second part or portion of the first surface of the heat sink disposed away from the IC in spaced relation to the substrate.

Clause 24: The system of clause 23, wherein a distal end of each leg disposed away from the body of the heat sink may be coupled to the substrate.

Clause 25: The system of clause 23 or 24, wherein the distal end of each leg may be coupled to the substrate via an adhesive.

Although this disclosure has been described in detail for the purpose of illustration based on what is currently considered to be the most practical and preferred embodiments, it is to be understood that such detail is solely for that purpose and that the disclosure is not limited to the disclosed embodiments, but, on the contrary, is intended to cover modifications and equivalent arrangements that are within the spirit and scope of the appended claims. For example, it is to be understood that the present disclosure contemplates that, to the extent possible, one or more features of any embodiment can be combined with one or more features of any other embodiment.

## Claims

1. A thermal dissipation system for integrated circuits comprising:
a substrate;
a set of integrated circuits (ICs) disposed on the substrate;
a carrier coupled to the substrate, the carrier having a side, including a set of openings, disposed in spaced relation to the substrate with the set of ICs disposed between the substrate and the set of openings; and
a set of heat sinks disposed on a surface of the side of the carrier opposite the set of ICs, wherein each heat sink includes a portion in contact with the surface of the side of the carrier opposite the set of ICs and a projection or extension that extends through one of the openings toward one of the ICs of the set of ICs.

2. The system of claim 1, wherein at least one of the following:
the set of ICs includes one or more ICs;
the set of openings includes one or more openings; and
the set of heat sinks includes one or more heat sinks.

3. The system of claim 1 or claim 2, further including a first set of thermal interfaces disposed between the set of ICs and the projection(s) or extension(s) of the set of heat sinks.

4. The system of any preceding claim, further including a second set of thermal interfaces disposed between the portion(s) of the set of heat sinks and the surface of the side of the carrier opposite the set of ICs.

5. The system of any preceding claim, further including a third set of thermal interfaces disposed on surface(s) of the set of heat sinks opposite the carrier.

6. The system of any preceding claim, wherein:
the carrier includes legs that extend from the carrier past one or more edges of the substrate; and
portions of the legs that that extend past the one or more edges of the substrate are bent or curved toward a surface of the substrate opposite the side of the carrier, optionally wherein the portions of the legs that that extend past the one or more edges of the substrate are bent or curved whereupon distal ends of the legs contact the surface of the substrate opposite the side of the carrier and further optionally wherein the portion of each leg that that extends past the one or more edges of the substrate is bent or curved into the form a J-shape or a hook.

7. A thermal dissipation system for integrated circuits comprising:
a substrate supporting an integrated circuit (IC);
a carrier including a side disposed in spaced relation to a side of the substrate supporting the IC;
a heat sink in contact with the IC, the heat sink including a projection or extension that extends from the IC through an opening in the side of the carrier and, after passage through the opening in the side of the carrier, the heat sink including a portion that extends away from the opening in the side of the carrier along a surface of the side of the carrier opposite the IC.

8. The system of claim 7, further including a first thermal interface disposed between the IC and the projection or extension of the heat sink.

9. The system of claim 7 or claim 8, further including a second thermal interface disposed between carrier and the portion of the heat sink.

10. The system of any of claims 7 to 9, further including third thermal interface disposed on a surface of the heat sink opposite the carrier.

11. The system of any of claims 7 to 10, further including
the substrate supporting another IC;
another heat sink in contact with the other IC, the other heat sink including a projection or extension extending from the other IC through another opening in the side of the carrier and, after passage through the other opening in the side of the carrier, the other heat sink including a portion that extends away from the other opening in the side of the carrier along the surface of the side of the carrier opposite the other IC and optionally wherein the portions of the heat sink and the other heat sink are spaced from each other on the carrier.

12. The system of any of claims 7 to 11, wherein:
the carrier includes legs that extend from the carrier past a surface of the substrate opposite the carrier; and
portions of the legs that that extend past the surface of the substrate opposite the carrier are bent or curved toward the surface of the substrate opposite the carrier and optionally wherein the portions of the legs that that extend past the surface of the substrate opposite the carrier are bent or curved whereupon distal ends of the legs contact the surface of the substrate opposite the carrier and further optionally wherein the portion of each leg that that extends past the surface of the substrate opposite the carrier is bent or curved into the form a J-shape or a hook.

13. A thermal dissipation system for integrated circuits comprising:
a heat sink having a first part including a planar or substantially planar first surface in contact with an integrated circuit (IC) that is mounted on a substrate and a second part spaced from the IC, wherein the second part includes a planar or substantially planar second surface that faces away from the first surface in spaced or substantially spaced parallel relation to the first surface, wherein the second surface has a surface area greater than the first surface; and
a carrier coupled between the substrate and the second part of the heat sink and supporting the second part of the heat sink in spaced or substantially spaced parallel relation to the substrate, wherein the first part of the heat sink extends between the IC and the second part of the heat sink through an opening in a surface of the carrier.

14. The system of claim 13, wherein the carrier is coupled to the substrate via legs that extend from the carrier to a side of the substrate opposite the carrier.

15. The system of claim 13 or claim 14, wherein the carrier includes standoffs that extend between the carrier and the substrate and maintain or support the carrier and the substrate in spaced relation.

16. A thermal dissipation system for integrated circuits comprising:
a substrate supporting an integrated circuit (IC);
a heat sink comprising a body having first surface including a first part or portion in contact with the IC, a second surface that faces away from the IC, and one or more legs that extend between the body of the heat sink and the substrate and support a second part or portion of the first surface of the heat sink disposed away from the IC in spaced relation to the substrate, optionally wherein a distal end of each leg disposed away from the body of the heat sink is coupled to the substrate and further optionally wherein the distal end of each leg is coupled to the substrate via an adhesive.

## Amended claims

### Amended claims in accordance with Rule 137(2) EPC.

1. A thermal dissipation system for integrated circuits comprising:
a substrate;
one or more integrated circuits (ICs) disposed on the substrate;
a carrier coupled to the substrate, the carrier having a side, including a set of openings, disposed in spaced relation to the substrate with the one or more ICs disposed between the substrate and the one or more openings; and
wherein the carrier includes legs that extend from the carrier past one or more edges of the substrate;
portions of the legs that that extend past the one or more edges of the substrate are bent or curved toward a surface of the substrate opposite the side of the carrier, optionally wherein the portions of the legs that that extend past the one or more edges of the substrate are bent or curved whereupon distal ends of the legs contact the surface of the substrate opposite the side of the carrier and further optionally wherein the portion of each leg that that extends past the one or more edges of the substrate is bent or curved into the form a J-shape or a hook; and
wherein the carrier includes standoffs that extend between the carrier and the substrate and maintain or support the carrier and the substrate in spaced relation; and
one or more heat sinks disposed on a surface of the side of the carrier opposite the one or more ICs, wherein each heat sink includes a portion in contact with the surface of the side of the carrier opposite the one or more ICs and a projection or extension that extends through one of the openings toward one of the ICs of the one or more ICs.

2. The system of claim 1 or claim 2, further including a first set of thermal interfaces disposed between the set of ICs and the projection(s) or extension(s) of the set of heat sinks.

3. The system of any preceding claim, further including a second set of thermal interfaces disposed between the portion(s) of the set of heat sinks and the surface of the side of the carrier opposite the set of ICs.

4. The system of any preceding claim, further including a third set of thermal interfaces disposed on surface(s) of the set of heat sinks opposite the carrier.
